(19) Europäisches Patentamt
European Patent Office
Office européen des brevets

(11) **EP 2 550 740 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **11708884.9**

(22) Anmeldetag: **21.03.2011**

(51) Int Cl.:
***H03K 17/945*** *(2006.01)*

(86) Internationale Anmeldenummer:
**PCT/EP2011/054186**

(87) Internationale Veröffentlichungsnummer:
**WO 2011/117165 (29.09.2011 Gazette 2011/39)**

(54) **ELEKTRONISCHES BAUTEIL FÜR EINE SENSORVORRICHTUNG, SENSORVORRICHTUNG UND VERFAHREN ZUM KONFIGURIEREN EINER SENSORVORRICHTUNG**

ELECTRONIC COMPONENT FOR A SENSOR DEVICE, SENSOR DEVICE, AND METHOD FOR CONFIGURING A SENSOR DEVICE

ÉLÉMENT ÉLECTRONIQUE POUR UN DISPOSITIF DE CAPTEUR, DISPOSITIF DE CAPTEUR ET PROCÉDÉ DE CONFIGURATION D'UN DISPOSITIF DE CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.03.2010 DE 102010003221**

(43) Veröffentlichungstag der Anmeldung:
**30.01.2013 Patentblatt 2013/05**

(73) Patentinhaber: **Balluff GmbH**
**73765 Neuhausen (DE)**

(72) Erfinder:
• FERICEAN, Sorin
71229 Leonberg (DE)
• KRÜPL, Frank
72141 Walddorfhäslach (DE)
• FRITTON, Markus
73765 Neuhausen (DE)
• REIDER, Thomas
70794 Bonlanden (DE)

(74) Vertreter: **Hoeger, Stellrecht & Partner Patentanwälte mbB**
**Uhlandstrasse 14c**
**70182 Stuttgart (DE)**

(56) Entgegenhaltungen:
DE-A1- 10 025 662    DE-C1- 4 123 828
DE-C1- 4 200 207    US-A- 5 408 132

• ANONYMOUS: "Getting Started. Microsoft Optical Mouse Products", Website , 7. März 2007 (2007-03-07), XP002660117, Gefunden im Internet: URL:http://ec1.images-amazon.com/media/i3d /01/A/man-migrate/MANUAL000041361.pdf [gefunden am 2011-09-27]

**Beschreibung**

Die Erfindung betrifft ein elektronisches Bauteil für eine Sensorvorrichtung, umfassend eine erste Anschlusseinrichtung zum Anschluss einer sensitiven Einrichtung, welche durch ein Target beeinflussbar ist, eine zweite Anschlusseinrichtung für die externe Kommunikation, und eine Steuerungseinrichtung und/oder eine Auswertungseinrichtung, welche Ausgangssignale bereitstellt, wobei das Bauteil über die zweite Anschlusseinrichtung programmierbar ist.

Weiterhin betrifft die Erfindung eine Sensorvorrichtung.

Weiterhin betrifft die Erfindung ein Verfahren zum Konfigurieren einer Sensorvorrichtung.

Aus der DE 41 23 828 C2 bzw. US 5,408,132 ist ein berührungslos arbeitender Näherungsschalter mit einem durch von außen herangeführte Gegenstände beeinflussbaren Schwingkreis, mit Auswerteeinrichtungen zum Erzeugen eines Ausgangssignals in Abhängigkeit von einer einen vorgegebenen Schwellwert überschreitenden Ausgangsgröße des Schwingkreises, mit einem äußeren elektrischen Anschluss zur Zuführung einer Versorgungsspannung und mindestens einem weiteren äußeren elektrischen Anschluss zur Ausgabe des Ausgangssignals und mit digitalen Einstelleinrichtungen zum Einstellen eines einstellbaren Schaltungsparameters bekannt. Die Einstelleinrichtungen sind als frei programmierbare, einen Datenspeicher umfassende Einstelleinrichtungen ausgebildet. Es ist eine ausgangsseitig mit den Einstelleinrichtungen verbundene Demodulationsschaltung vorgesehen, welcher eingangsseitig über einen der für die Schalterfunktion des Näherungsschalters erforderlichen äußeren elektrischen Anschlüsse Programmierdaten in Form von den Ausgangssignalen und/oder elektrischen Potentialen an die betreffenden äußeren elektrischen Anschlüsse überlagerten oder aufmodulierten Daten zuführbar sind.

Aus der DE 100 25 662 A1 ist ein Näherungssensor mit einem Oszillator bekannt, welcher durch einen von außen heranführbaren Gegenstand beeinflussbar ist, mit Auswerteeinrichtungen zur Erzeugung eines analogen Ausgangssignals in Abhängigkeit eines Messabstands zwischen Gegenstand und Oszillator und mit einem Ausgangsanschluss, an welchem das analoge Ausgangssignal abgreifbar ist. In den Sensor ist eine Schaltpunkt-Auswerteeinheit integriert, durch welche ein digitales Ausgangssignal bereitstellbar ist, das die Information enthält, ob ein detektierter Messabstand oberhalb oder unterhalb eines vorgegebenen Schaltpunkts liegt. Es ist ein Ausgangsanschluss für das digitale Ausgangssignal vorgesehen.

Aus der DE 42 00 207 C1 ist ein elektronisches Schaltgerät mit mindestens einem den Schaltabstand bestimmenden, hinsichtlich seines den Schaltabstand bestimmenden Zustands einstellbaren Schaltabstandbestimmungselement und mindestens zwei extern belegbaren Anschlüssen bekannt. Der Zustand des Schaltabstandbestimmungselements und damit der Schaltabstand ist über die extern belegbaren Anschlüsse einstellbar, es wird nämlich in Abhängigkeit vom Anschluss des Schaltgeräts an die Versorgungsspannung mindestens ein Steuersignal zur Einstellung des Zustands des Schaltabstandbestimmungselements gewonnen.

Aus der DE 43 31 555 A1 ist eine Näherungsschaltung mit Mitteln zur Umschaltung zwischen dem normalen Betriebsmodus und einem Lernmodus, mit Mitteln zur Festlegung von Betriebsfunktionen im Lernmodus unter Ausschluss von Überstrom-Überwachungseinrichtungen zu diesem Zweck und mit Mitteln zur Speicherung der festgelegten, zum Betrieb des Näherungsschalters im Betriebsmodus dienenden Betriebsfunktion bekannt.

Der Erfindung liegt die Aufgabe zugrunde, ein elektronisches Bauteil der eingangs genannten Art bereitzustellen, welches universell einsetzbar ist.

Diese Aufgabe wird bei dem eingangs genannten elektronischen Bauteil erfindungsgemäß dadurch gelöst, dass eine erste Programmierebene vorgesehen ist, in welcher Parameter für den Setup der Sensorvorrichtung einstellbar sind, und eine zweite Programmierebene vorgesehen ist, in welcher eine Kennlinie der Sensorvorrichtung einstellbar ist, wobei die erste Programmierebene der zweiten Programmierebene hierarchisch übergeordnet ist und Einstellungen und/oder Einstellungsmöglichkeiten in der zweiten Programmierebene abhängig sind von Einstellungen in der ersten Programmierebene, und dass eine Widerstandseinrichtung vorgesehen ist, welche mindestens einen einstellbaren Widerstand umfasst.

Das erfindungsgemäße elektronische Bauteil lässt sich für eine Vielzahl unterschiedlicher Sensorvorrichtungen verwenden, wobei die Sensorvorrichtungen von der gleichen Art sein können (mit der gleichen Art an sensitiven Einrichtungen) und in der gleichen Art für unterschiedliche Familien einsetzbar sind. Es ist auch möglich, das elektronische Bauteil für unterschiedliche Arten von Sensorvorrichtungen mit unterschiedlichen Arten von sensitiven Einrichtungen einzusetzen. Beispielsweise ist es möglich, das entsprechende Bauteil für eine induktive Sensorvorrichtung oder für eine kapazitive Sensorvorrichtung zu verwenden. Bestimmte grundlegende Einstellungen werden in der ersten Programmierebene vorgenommen. Eine Sensorkennlinie (Input-Output-Übertragungsfunktion) lässt sich in der zweiten Programmierebene ei nstellen.

Durch die entsprechende Einstellbarkeit lässt sich das elektronische Bauteil grundsätzlich zu jedem Zeitpunkt programmieren. Bestimmte Einstellungen können an dem "nackten" elektronischen Bauteil vorgenommen werden. Andere Einstellungen, wie beispielsweise ein Abgleich der analogen und/oder digitalen Sensorkennlinie und/oder die Einstellung eines Schaltabstands, werden mit angeschlossener sensitiver Einrichtung vorgenommen. Es ist dabei möglich, die Sensorkennlinie beispielsweise bei geschlossenem Gehäuse einzustellen.

Zum Betrieb einer Sensorvorrichtung sind zusätzlich zu einem erfindungsgemäßen elektronischen Bauteil und einer sensitiven Einrichtung keine weiteren externen passiven und aktiven Bauteile notwendig. Die Funktionalität der Sensorvorrichtung ist durch das elektronische Bauteil realisiert. Auch Schutzfunktionen beispielsweise für Kurzschlussschutz, Überlastschutz, Verpolschutz, bei Kabelbruch usw. lassen sich in das entsprechende elektronische Bauteil integrieren.

Es ist dabei möglich, dass die sensitive Einrichtung dem elektronischen Bauteil analoge oder digitale Signale bereitstellt. Das elektronische Bauteil und insbesondere eine Sensorvorrichtung, welche das elektronische Bauteil umfasst, stellt an der zweiten Anschlusseinrichtung analoge und/oder digitale Signale bereit.

Das erfindungsgemäße elektronische Bauteil weist mindestens zwei Programmierebenen auf. Es können auch noch weitere Programmierebenen vorgesehen sein. Beispielsweise ist eine dritte Programmierebene vorgesehen, welche hierarchisch der zweiten Programmierebene untergeordnet ist und in der beispielsweise einstellbar ist, ob eine Sensorvorrichtung, welche mit dem elektronischen Bauteil versehen ist, als Öffner oder Schließer wirken soll. Grundsätzlich ist es auch möglich, noch weitere Programmierebenen wie beispielsweise eine vierte Programmierebene vorzusehen, welche dann der dritten Programmierebene hierarchisch untergeordnet ist. Diese vierte Programmierebene ist beispielsweise eine Programmierebene, in der ein Benutzer Einstellungen vornehmen kann. Es ist dabei dann grundsätzlich vorgesehen, dass bei der Herstellung und Konditionierung verwendete Programmierebenen (insbesondere die erste Programmierebene und die zweite Programmierebene) irreversibel verriegelt sind, bevor ein Benutzer auf eine benutzerspezifische Programmierebene zugreifen kann, falls eine solche Programmierebene existiert.

Insbesondere weist die erste Anschlusseinrichtung mindestens einen Anschluss für eine sensitive Einrichtung auf, welche ein oder mehrere sensitive Elemente aufweist, die auf elektromagnetische Felder reagieren. Entsprechende Sensorsignale werden dem elektronischen Bauteil zur Weiterverarbeitung bereitgestellt.

Insbesondere ist eine Sensoreinheit zur Ansteuerung dieser sensitiven Einrichtung vorgesehen. Die entsprechende reaktive sensitive Einrichtung, wie beispielsweise eine induktive sensitive Einrichtung, benötigt Ansteuerungssignale. Diese werden durch das elektronische Bauteil bereitgestellt.

Es ist grundsätzlich auch möglich, dass alternativ oder zusätzlich die erste Anschlusseinrichtung mindestens einen Anschluss für eine sensitive Einrichtung umfasst, für welche keine Ansteuerbarkeit durch das elektronische Bauteil vorgesehen ist. Die sensitive Einrichtung gibt dann entsprechende Signale an das elektronische Bauteil weiter, ohne dass eine Rückwirkung des elektronischen Bauteils auf die sensitive Einrichtung notwendig ist. Beispiele für solche sensitiven Einrichtungen, die analoge und/oder digitale Signale bereitstellen können, sind induktive, kapazitive, magnetfeldempfindliche, sensitive Einrichtungen oder auch sensitive Einrichtungen für Ultraschall, optische Signale, Mikrowellen usw.

Die erste Anschlusseinrichtung weist beispielsweise mindestens einen Anschluss für eine induktive sensitive Einrichtung und/oder eine kapazitive sensitive Einrichtung und/oder eine magnetfeldsensitive Einrichtung auf. Dadurch ist das gleiche elektronische Bauteil variabel einsetzbar.

Insbesondere weist die erste Anschlusseinrichtung getrennte Anschlüsse für unterschiedliche Arten von sensitiven Einrichtungen auf. Es gibt beispielsweise sensitive Einrichtungen, die nicht schaltend sind, wie beispielsweise eine induktive sensitive Einrichtung, oder sensitive Einrichtungen, die schaltend sind, wie beispielsweise eine magnetfeldsensitive Einrichtung. Entsprechend muss die Beschaltung in dem elektronischen Bauteil unterschiedlich sein. Dies kann mittels unterschiedlichen Anschlüssen berücksichtigt werden.

In der ersten Programmierebene sind grundsätzliche Einstellungen durchführbar. Insbesondere sind mindestens eine der folgenden Einstellungen durchführbar: Einsatz des Bauteils insbesondere im Zusammenhang mit der sensitiven Einrichtung, Einstellungen bezüglich der Art der sensitiven Einrichtung, Einstellungen zur Festlegung von Sensorkenndaten, wobei die Sensorkenndaten eine oder mehrere der Parameter maximaler Ausgangsstrom, Hysterese eines Ausgangsschaltsignals, Signalhöhe umfassen können, Einstellungen der Anpassung der sensitiven Einrichtung, Konfigurieren von Vorwiderstandswerten, Konfigurieren von Schrittweiten bei Abgleichswiderständen, Konfigurieren des Werteverlaufs bei Abgleichwiderständen. Die erste Programmierebene ist eine Designebene, in welcher ein Sensordesigner die grundlegenden Setup-Parameter für die gewünschte Sensorvorrichtung einstellt.

In der zweiten Programmierebene ist insbesondere ein Teach-in-Abgleich für die Kennlinie und/oder ein direktes Einstellen für die Kennlinie durchführbar. Die zweite Programmierebene ist eine Art Fertigungsebene, in der die Sensorvorrichtung für eine Anwendung konfiguriert wird. Die Kennlinie ist eine insbesondere stetig monotone Input-Output-Übertragungsfunktion.

Es ist vorteilhaft, wenn eine dritte Programmierebene vorgesehen ist, welche der zweiten Programmierebene hierarchisch untergeordnet ist, und in welcher mindestens eine der Einstellungen Typ eines Schaltausgangs, Freigabe eines Schaltausgangs, Schaltfunktion als Öffner oder Schließer, Modus einer Anzeigeeinrichtung einstellbar ist. Die in der dritten Programmierebene einstellbaren Funktionen bzw. Parameter haben keine Rückwirkung auf die in der ersten Programmierebene und der zweiten Programmierebene einstellbaren Parameter. Die dritte Programmierebene ist beispielsweise eine Logistikebene, in welcher bestimmte Funktionen nach Kundenwünschen eingestellt werden. Die Einstellung erfolgt dabei softwaremäßig, sodass Hardwarevorhaltekosten minimiert sind. Wenn die Freigabe eines Schaltausgangs gesperrt wird, dann kann beispielsweise das elektronische Bauteil (mit angeschlossenem sensitiven Element) als stromsparende sensitive Einrichtung ohne Freigabe einer Ausgangseinheit eingesetzt werden.

Insbesondere weist das elektronische Bauteil eine dritte Anschlusseinrichtung für eine Anzeigeeinrichtung und/oder Sensorzustandsdaten auf. Über die Anzeigeeinrichtung können dann Zustände der Sensorvorrichtung oder beispielsweise in einer Programmierphase auch Zustände des elektronischen Bauteils insbesondere optisch angezeigt werden. Beispielsweise kann über die dritte Anschlusseinrichtung ein Temperaturinformationssignal abgegriffen werden. Beispielsweise kann eine temperaturunabhängige Spannung abgegriffen werden und/oder es lassen sich zwei insbesondere lineare temperaturabhängige Spannungen steigender beziehungsweise fallender Charakteristik abgreifen.

Bei einer Ausführungsform ist mindestens ein Anschluss vorgesehen, an welchem eine Arbeitsfrequenz abgreifbar ist. Diese Arbeitsfrequenz lässt sich beispielsweise für die Steuerung von Anwendungen nutzen.

Günstig ist es, wenn eine Programmierebene verriegelbar ist. Dadurch kann beispielsweise gewährleistet werden, dass in der zweiten Programmierebene Setup-Einstellungen der ersten Programmierebene nicht verändert werden können. Es kann dabei eine Gesamtverriegelung gleichzeitig für alle Programmierebenen vorgesehen sein und/oder es können Einzelverriegelungen für individuelle Programmierebenen vorgesehen sein.

Grundsätzlich ist es vorteilhaft, wenn einstellbar ist, ob eine Programmierebene reversibel oder irreversibel verriegelbar ist. Es kann beispielsweise günstig sein, wenn Programmierebenen reversibel verriegelbar sind. Wenn beispielsweise falsche Einstellungen oder für eine Anwendung ungeeignete Einstellungen vorgenommen wurden, können die Einstellungen zurückgesetzt werden und in neuen Programmierschritten kann eine korrekte Einstellung durchgeführt werden. Wenn beispielsweise eine nicht geeignete Sensorvorrichtung-Kennlinie eingestellt wurde, dann kann dies rückgängig gemacht werden und die entsprechende Sensorvorrichtung muss nicht verworfen werden. Dadurch lässt sich der Ausschussanteil minimieren.

Günstig ist es, wenn eine Reset-Funktion vorgesehen ist, mittels welcher Einstellungen in einer oder mehreren oder allen Programmierebenen auf vorgegebene Einstellungen zurücksetzbar sind ("Default-Preset"). Dadurch lässt sich für eine Programmierebene oder für mehrere Programmierebenen oder für alle Programmierebenen ein Grundzustand auf schnelle Weise erreichen. Es können dann Neueinstellungen vorgenommen werden. Dadurch lässt sich der Ausschussanteil minimieren, wobei das Zurücksetzen auf einfache Weise durchführbar ist. Insbesondere ist dabei die Reset-Funktion verriegelbar.

Grundsätzlich ist ein Zeitpunkt für eine Programmierung frei wählbar. Über die zweite Anschlusseinrichtung lässt sich auf die Programmierebenen zugreifen und je nach vorgesehener Programmierung kann diese an dem "nackten" elektronischen Bauteil, wenn dieses auf einer Platine installiert ist, oder bei geschlossenem Gehäuse durchgeführt werden.

Das elektronische Bauteil umfasst insbesondere eine Digitaleinheit. Die Digitaleinheit enthält beispielsweise Steuerungselemente zur Ansteuerung einer sensitiven Einrichtung und/oder Komponenten zur Signalauswertung.

Beispielsweise ist die Auswertungseinrichtung, welche aus Signalen der sensitiven Einrichtung weiterverarbeitbare Ausgangssignale bereitstellt, mindestens teilweise in die Digitaleinheit integriert.

Es kann vorgesehen sein, dass die Digitaleinheit mindestens eines der folgenden Bestandteile umfasst: Taktgeber, Speichereinrichtung, Zentralprozessor.

Das elektronische Bauteil umfasst ferner eine Sensoreinheit, welche mit der ersten Anschlusseinrichtung in signalwirksamer Verbindung steht. Die Sensoreinheit ist diejenige Einheit des elektronischen Bauteils, welche direkt mit der sensitiven Einrichtung kommuniziert und Signale von dieser empfängt und/oder diese direkt ansteuert.

Günstig ist es, wenn die Sensoreinheit einen Oszillator umfasst. Es lässt sich dann beispielsweise eine induktive sensitive Einrichtung entsprechend ansteuern.

Es ist ferner günstig, wenn die Sensoreinheit ein Detektor für Signale der sensitiven Einrichtung umfasst. Dadurch lassen sich entsprechende auswertbare Signale generieren.

Bei einer Ausführungsform ist mindestens ein Anschluss vorgesehen, an welchem Analogsignale des Detektors abgreifbar sind. Beispielsweise lässt sich ein Analogsignal abgreifen, dessen Wert (insbesondere Gleichspannungswert) proportional zu einem Targetabstand ist.

Ferner ist es vorgesehen, dass das elektronische Bauteil eine Signalkonditionierungseinheit umfasst. In dieser Signalkonditionierungseinheit lassen sich beispielsweise über Komparatorvorgänge auswertbare Signale gewinnen.

Es ist ferner günstig, wenn eine Ausgangseinheit vorgesehen ist. Die Ausgangseinheit kommuniziert direkt mit externen Einrichtungen und stellt beispielsweise Ausgangssignale bereit. Über die Ausgangseinheit lässt sich auch elektrische Energie einkoppeln.

Es ist günstig, wenn die Ausgangseinheit einen Kurzschlussdetektor und/oder Überlastdetektor umfasst, um das elektronische Bauteil und eine entsprechende Sensorvorrichtung bei Kurzschlüssen zu schützen. Grundsätzlich lässt sich der Kurzschlussdetektor auch verwenden, um über entsprechende Signale das elektronische Bauteil bzw. eine Sensorvorrichtung programmieren zu können.

Das elektronische Bauteil umfasst eine Widerstandseinrichtung, welche mindestens einen einstellbaren Widerstand umfasst. Die Widerstandseinrichtung ist beispielsweise an einen Oszillator angeschlossen. Über die Widerstandseinrichtung lässt sich ein Sensorabgleich durchführen und insbesondere lässt sich eine Kennlinie bei einer induktiven Sensorvorrichtung einstellen.

Bei einer Ausführungsform umfasst die Widerstandseinrichtung eine Vorwiderstandseinrichtung, deren Widerstandswert einstellbar ist. Der Widerstandswert der Vorwiderstandseinrichtung wird insbesondere in der ersten Programmierebene eingestellt.

Es ist dabei günstig, wenn die Vorwiderstandseinrichtung eine Mehrzahl von seriell geschalteten und/oder seriell schaltbaren Widerständen aufweist. Über Einstellung der Anzahl der seriell geschalteten Widerstände lässt sich dann der Widerstandswert der Vorwiderstandseinrichtung einstellen.

Ferner günstig ist es, wenn die Widerstandseinrichtung eine Trimmwiderstandseinrichtung aufweist, wobei deren Widerstandswert und der Verlauf der Widerstandsänderungen einstellbar ist. Die Trimmwiderstandseinrichtung wird für Abgleichvorgänge zur Kennlinieneinstellung oder Schaltpunkteinstellung verwendet. Der Widerstandswert wird insbesondere in der zweiten Programmierebene eingestellt. Der grundsätzliche Verlauf bei Widerstandsänderung (linear oder nichtlinear) wird insbesondere in der ersten Programmierebene eingestellt.

Die Trimmwiderstandseinrichtung umfasst insbesondere eine Mehrzahl von parallel geschalteten und/oder parallel schaltbaren Widerständen. Dadurch ergeben sich umfangreiche Einstellungsmöglichkeiten. Insbesondere umfasst die Trimmwiderstandseinrichtung eine Mehrzahl von parallel geschalteten Widerstandsreihen, wobei die Widerstandsreihen wiederum eine Mehrzahl von seriell geschalteten Widerständen umfassen. Es ergibt sich dadurch ein Widerstandsnetzwerk mit umfangreichen Einstellungsmöglichkeiten.

Insbesondere ist einstellbar, ob der Verlauf der Widerstandsänderung linear oder nichtlinear und insbesondere exponentiell ist.

Die Widerstandseinrichtung bildet ein Widerstandsnetzwerk, welches seriell schaltbare Widerstände und parallel schaltbare Widerstände umfasst, wobei eine Schaltkombination einstellbar ist. Die Schaltkombination wird insbesondere in der zweiten Programmierebene eingestellt. Es ergibt sich dadurch eine genaue und definierte Abgleichsmöglichkeit zur Einstellung einer Kennlinie.

Das erfindungsgemäße Bauteil lässt sich als Masterbauteil für eine Sensorvorrichtung und beispielsweise eine induktive Sensorvorrichtung mit einer induktiven sensitiven Einrichtung verwenden. In diesem Falle steuert das elektronische Bauteil die (induktive) sensitive Einrichtung an und ist auch eine Endstufe (Backend) für die Sensorvorrichtung.

Es ist auch möglich, dass das elektronische Bauteil nur als Endstufe für eine Sensorvorrichtung verwendet wird und dabei insbesondere die sensitive Einrichtung nicht ansteuert. Dies ist beispielsweise möglich, wenn die sensitive Einrichtung schaltend ist und dem elektronischen Bauteil direkt ein Schaltsignal bereitstellt. Auch wenn die sensitive Einrichtung ein Analogsignal bereitstellt, ist eine Verwendung nur als Endstufe möglich.

Beispiele für schaltende sensitive Einrichtungen sind kapazitive sensitive Einrichtungen und magnetfeldsensitive Einrichtungen.

Erfindungsgemäß wird eine Sensorvorrichtung bereitgestellt, welche ein erfindungsgemäßes Bauteil und eine sensitive Einrichtung (mit mindestens einem sensitiven Element) umfasst, welche an das Bauteil angeschlossen ist.

Insbesondere sind das Bauteil und die sensitiven Einrichtung im gleichen Gehäuse angeordnet. Ein zu detektierendes Target (insbesondere bezüglich Abstand bzw. Annäherung) ist außerhalb dieses Gehäuses positioniert.

Die sensitive Einrichtung ist dabei beispielsweise eine induktive sensitive Einrichtung und/oder kapazitive sensitive Einrichtung und/oder magnetfeldsensitive Einrichtung und/oder optisch sensitive Einrichtung.

Erfindungsgemäß wird ein Verfahren zum Konfigurieren einer erfindungsgemäßen Sensorvorrichtung bereitgestellt, bei dem in der ersten Programmierebene Setup-Parameter der Sensorvorrichtung eingestellt werden, anschließend mit der zweiten Programmierebene eine Kennlinie eingestellt wird, und bei dem die erste und die zweite Programmierebene verriegelt werden.

Es ist dabei grundsätzlich möglich, dass nach Abschluss der Einstellungsarbeiten an der ersten Programmierebene die erste Programmierebene verriegelt wird bevor in der zweiten Programmierebene gearbeitet wird. Nach Abschluss der Arbeiten der zweiten Programmierebene wird dann diese verriegelt. Es ist auch möglich, dass nach Abschluss der Einstellungsarbeiten in der ersten Programmierebene und der zweiten Programmierebene und gegebenenfalls in einer oder mehreren weiteren Programmierebenen eine Gesamtverriegelung stattfindet.

Das erfindungsgemäße Verfahren weist die bereits im Zusammenhang mit dem erfindungsgemäßen elektronischen Bauteil und der erfindungsgemäßen Sensorvorrichtung erläuterten Vorteile auf.

Es ist ferner günstig, wenn in einer dritten Programmierebene Sensorfunktionen eingestellt werden und die dritte Programmierebene verriegelt wird.

Die nachfolgende Beschreibung bevorzugter Ausführungsformen dient im Zusammenhang mit den Zeichnungen der näheren Erläuterung der Erfindung. Es zeigen:

Figur 1    eine schematische Darstellung eines Ausführungsbeispiels einer erfindungsgemäßen Sensorvorrichtung mit einem erfindungsgemäßen elektronischen Bauteil;

Figur 2      eine schematische Darstellung von Programmierebenen für ein erfindungsgemäßes elektronisches Bauteil;

Figur 3      eine Ersatzschaltbilddarstellung einer Widerstandseinrichtung des elektronischen Bauteils gemäß Figur 1;

Figur 4      Darstellungen von Möglichkeiten der Widerstandsänderung für die Widerstandseinrichtung gemäß Figur 3;

Figur 5      ein Ausführungsbeispiel einer Widerstandseinrichtung; und

Figur 6      ein weiteres Ausführungsbeispiel einer Sensorvorrichtung mit einem erfindungsgemäßen elektronischen Bauteil.

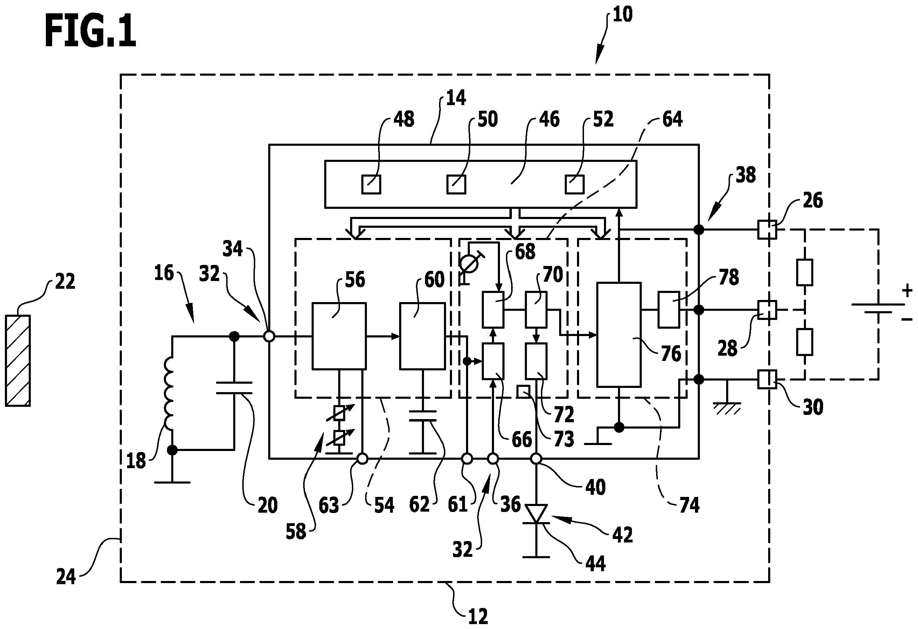

Ein Ausführungsbeispiel einer Sensorvorrichtung, welche in Figur 1 schematisch gezeigt und dort mit 10 bezeichnet ist, umfasst ein Gehäuse 12. In dem Gehäuse 12 ist (unter anderem) ein elektronisches Bauteil 14 angeordnet und ist eine sensitive Einrichtung 16 angeordnet.

Bei dem gezeigten Ausführungsbeispiel ist die sensitive Einrichtung 16 eine induktive sensitive Einrichtung, welche (mindestens) eine Spule 18 und (mindestens) eine Kapazität 20 umfasst, welche beispielsweise parallel geschaltet sind. Die Spule 18 und die Kapazität 20 bilden einen Schwingkreis.

Ein Target 22 und insbesondere ein metallisches Target 22 außerhalb des Gehäuses 12 beeinflusst diesen Schwingkreis und über die Beeinflussung lässt sich beispielsweise der Abstand des Targets 22 zu einer Vorderseite 24 des Gehäuses 12 ermitteln, wobei die sensitive Einrichtung 16 im Bereich dieser Vorderseite in dem Gehäuse 12 angeordnet ist.

Die Sensorvorrichtung 10 ist insbesondere als Näherungssensor oder Abstandssensor ausgebildet. Sie kann dabei analoge Signale bereitstellen und/oder digitale Signale. (Im letzteren Falle ist die Sensorvorrichtung 10 ein Näherungsschalter.)

Es ist beispielsweise auch möglich, dass die sensitive Einrichtung 16 durch eine spannungsgesteuerte Quelle gebildet ist, welche von dem Target 22 beeinflussbar ist.

Die Sensorvorrichtung 10 weist Anschlüsse 26, 28, 30 auf, welche insbesondere an dem Gehäuse 12 angeordnet sind. Die Anschlüsse 26, 28, 30 dienen zur externen Kommunikation der Sensorvorrichtung 10. Über die Anschlüsse 26, 28, 30, welche insbesondere über einen Stecker oder ein Gegenstück zu einem Stecker oder ein Kabel realisiert sind, lässt sich die Sensorvorrichtung 10 mit elektrischer Energie versorgen und es lassen sich Sensorsignale (Ausgangssignale) abgreifen.

Das elektronische Bauteil 14 ist ein integriertes elektronisches Bauteil, welches bei der Sensorvorrichtung 10 die Steuerungszentrale und Auswertungszentrale ist. Das elektronische Bauteil 14 ist beispielsweise ein ASIC (Application Specific Integrated Circuit).

Das elektronische Bauteil 14 weist eine erste Anschlusseinrichtung 32 auf, an welche eine sensitive Einrichtung anschließbar ist. Bei einer Ausführungsform umfasst dabei die erste Anschlusseinrichtung 32 mehrere Anschlüsse 34, 36. Es kann vorgesehen sein, dass getrennte Anschlüsse 34, 36 für unterschiedliche Arten von sensitiven Einrichtungen vorgesehen sind und entsprechend dann auch die interne Beschaltung für die Anschlüsse 34, 36 an dem elektronischen Bauteil 14 unterschiedlich ist.

Beispielsweise ist es möglich, dass der Anschluss 34 zum Anschluss einer induktiven sensitiven Einrichtung 16 vorgesehen ist und der Anschluss 36 zum Anschluss einer kapazitiven sensitiven Einrichtung. Dadurch lässt sich das elektronische Bauteil 14 beispielsweise sowohl für eine induktive Sensorvorrichtung 10 als auch für eine kapazitive Sensorvorrichtung verwenden (siehe unten).

Beispielsweise ist es dadurch auch grundsätzlich möglich, eine Sensorvorrichtung 10 bereitzustellen, welche unterschiedliche Arten von sensitiven Einrichtungen umfasst, wie beispielsweise eine induktive sensitive Einrichtung und eine kapazitive sensitive Einrichtung. Eine solche Sensorvorrichtung kann beispielsweise als Gratsonde eingesetzt werden.

Das elektronische Bauteil 14 weist ferner eine zweite Anschlusseinrichtung 38 auf, welche mit den Anschlüssen 26, 28, 30 in signalwirksamer Verbindung steht. Die zweite Anschlusseinrichtung 38 dient zur externen Kommunikation des elektronischen Bauteils 14. Über sie lässt sich dem elektronischen Bauteil 14 elektrische Energie zuführen und es lassen sich Ausgangssignale auskoppeln.

Das elektronische Bauteil 14 umfasst weiterhin eine dritte Anschlusseinrichtung 40. An die dritte Anschlusseinrichtung ist (mindestens) eine Anzeigeeinrichtung 42, welche insbesondere eine oder mehrere Leuchtdioden 44 umfasst, anschließbar. Es können auch noch weitere Anschlusseinrichtungen vorgesehen sein.

Über die Anzeigeeinrichtung 42 lässt sich beispielsweise eine Zustandsanzeige für die Sensorvorrichtung 10 realisieren.

Das elektronische Bauteil 14 weist eine integrierte Digitaleinheit 46 auf. Durch diese Digitaleinheit 46 ist eine Steuerungseinrichtung realisiert, welche weitere Komponenten wie eine Sensoreinheit 54, eine Signalkonditionierungseinrichtung 64 und eine Ausgangseinheit 74 ansteuert (siehe unten).

Die Digitaleinheit 46 umfasst insbesondere die Komponenten Taktgeber 48, Speichereinrichtung 50 und Zentralprozessor 52.

Eine Auswertungseinrichtung ist insbesondere mindestens teilweise in die Digitaleinheit 46 integriert.

Das elektronische Bauteil 14 umfasst weiterhin eine Sensoreinheit 54. Diese Sensoreinheit 54 steht in signalwirksamer Verbindung mit der ersten Anschlusseinrichtung 32 und insbesondere dem Anschluss 34. Sie umfasst einen Oszillator 56. An den Oszillator 56 ist eine einstellbare Widerstandseinrichtung 58 angeschlossen. Über die Widerstandseinrichtung 58 lässt sich beispielsweise eine Kennlinie der Sensorvorrichtung 10 und/oder einen Schaltabstand einstellen.

Die Sensoreinheit 54 umfasst weiterhin einen Detektor 60 mit angeschlossener Kapazität 62. Der Detektor 60 detektiert Signale, die durch die Beeinflussung des Targets 22 charakterisiert sind.

Bei einer Ausführungsform ist dem Detektor 60 ein Anschluss 61 zugeordnet. An diesem Anschluss 61 lässt sich beispielsweise ein Gleichspannungswert abgreifen, welcher proportional zu einem Abstand des Targets 22 ist.

Es kann auch ein Anschluss 63 vorgesehen sein, welcher mit dem Oszillator 56 verbunden ist und an dem sich eine Arbeitsfrequenz abgreifen lässt.

Das elektronische Bauteil 14 umfasst weiterhin eine Signalkonditionierungseinrichtung 64. Der Detektor 60 stellt dieser Signalkonditionierungseinrichtung 64 entsprechende Signale bereit. Dazu umfasst die Signalkonditionierungseinrichtung 64 beispielsweise einen Umschalter 66, beispielsweise in Form eines analogen Multiplexers.

Der Anschluss 36 steht in signalwirksamer Verbindung mit dem Umschalter 66.

Die Signalkonditionierungseinrichtung 64 umfasst weiterhin einen Komparator 68, welcher dem Umschalter 66 nachgeschaltet ist. Der Komparator 68 weist einen Schaltschwelleneingang auf, über den seine Schaltschwelle einstellbar ist. Dem Komparator 68 wiederum nachgeschaltet ist eine Logikeinheit 70. Der Logikeinheit 70 ist ein Treiber 72 für die Anzeigeeinrichtung 42 nachgeschaltet. Dieser Treiber 72 steht in signalwirksamer Verbindung mit der dritten Anschlusseinrichtung 40.

Bei einer Ausführungsform umfasst die Signalkonditionierungseinrichtung 64 eine temperaturgesteuerte Spannungsquelle 73. Diese temperaturgesteuerte Spannungsquelle 73 liefert Temperaturinformationen bezüglich des "Innenlebens" des elektronischen Bauteils 14 und/oder über das Innere des Gehäuses 12. Beispielsweise werden drei Spannungen bereitgestellt, nämlich eine konstante temperaturunabhängige Spannung und zwei lineare temperaturabhängige Spannungen mit steigender beziehungsweise fallender Charakteristik.

Das elektronische Bauteil 14 umfasst weiterhin eine Ausgangseinheit 74. Die Ausgangseinheit 74 weist eine Ausgangsstufe 76 auf, an welche die Logikeinheit 70 signalwirksam gekoppelt ist.

Bei einer Ausführungsform umfasst die Ausgangseinheit 74 einen Kurzschlussdetektor 78 und/oder Überlastdetektor, welcher zur Detektion von Kurzschlüssen beziehungsweise Überlasten vorgesehen ist und bei Detektion eines Kurzschlusses beziehungsweise Überlast Komponenten des elektronischen Bauteils 14 schützt.

Die Ausgangsstufe 74 steht in signalwirksamer Verbindung mit der Digitaleinheit 46. Die Digitaleinheit 46 steuert wie oben erwähnt die Sensoreinheit 54, die Signalkonditionierungseinrichtung 64 und die Ausgangseinheit 74 an.

Das elektronische Bauteil 14 ist programmierbar. Wenn das elektronische Bauteil 14 in einen Programmiermodus gesetzt wurde (welcher beispielsweise über die Anzeigeeinrichtung 42 angezeigt ist), dann lassen sich Parameter beeinflussen. Der Programmiermodus wird über entsprechende Signalbeaufschlagung an der zweiten Anschlusseinrichtung 38 erreicht. Die Programmierung erfolgt über Signalbeaufschlagung an der zweiten Anschlusseinrichtung 38. Es werden dabei entsprechende Programmierbefehle beispielsweise in der Form von Mehrbitworten verwendet.

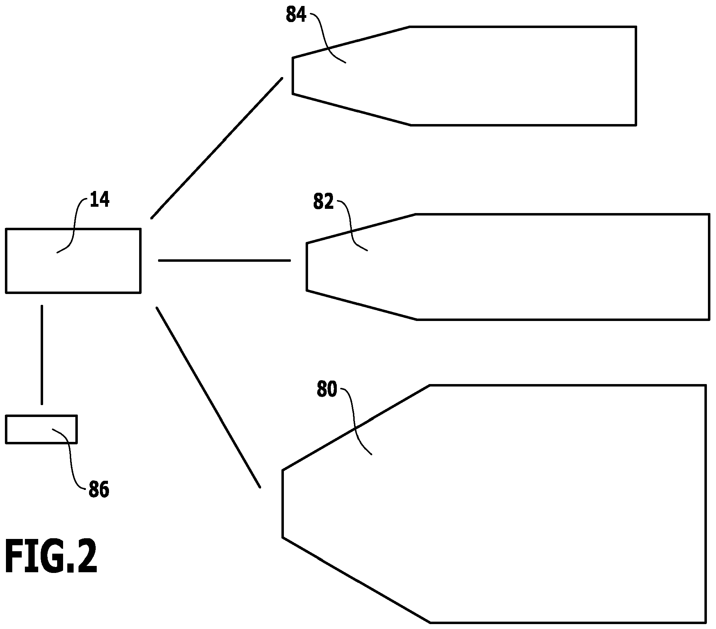

Das elektronische Bauteil 14 umfasst eine Mehrzahl von Programmierebenen 80, 82, 84 (Figur 2).

Es ist eine erste Programmierebene 80 vorgesehen, welche hierarchisch einer zweiten Programmierebene 82 übergeordnet ist. Die zweite Programmierebene 82 ist wiederum hierarchisch einer dritten Programmierebene 84 übergeordnet. Es können grundsätzlich noch weitere (untergeordnete) Programmierebenen vorgesehen sein. Die hierarchische Ordnung bedeutet dabei, dass Einstellungen in einer untergeordneten Programmierebene keine Einwirkungen auf die Einstellungen in einer übergeordneten Programmierebene haben.

In der ersten Programmierebene 80 sind grundlegende Parameter der Sensorvorrichtung 10 einstellbar. Insbesondere sind Parameter für den Setup der Sensorvorrichtung 10 einstellbar. In der ersten Programmierebene 80 ist beispielsweise einstellbar, ob das elektronische Bauteil 14 als Zentrale (Masterbauteil) für eine Sensorvorrichtung 10 wie beispielsweise induktive Sensorvorrichtung 10 eingesetzt wird oder als "Backend" (als eine Art von Ausgangsstufe) für eine Sensorvorrichtung beispielsweise mit einer schaltenden sensitiven Einrichtung wie beispielsweise einer magnetfeldsensitiven Einrichtung oder einer kapazitiven Einrichtung.

In der ersten Programmierebene 80 sind ferner beispielsweise bestimmte grundlegende Sensorvorrichtungs-Kenndaten wie ein maximaler Ausgangsstrom, die Hysterese eines Ausgangsschaltsignals (beispielsweise 5 %, 7,5 %, 10 % oder 15 %), und/oder eine Signalhöhe oder Detektionsschwelle einstellbar.

Ferner ist beispielsweise eine Anpassung an die sensitive Einrichtung 16 einstellbar. Beispielsweise ist eine Spulenanpassung einstellbar über beispielsweise eine Teach-in-Schwingfrequenz.

Ferner sind bestimmte grundlegende Parameter für die Widerstandseinrichtung 58 einstellbar. Beispielsweise ist, wie untenstehend noch näher erläutert wird, ein Vorwiderstandswert einstellbar. Ferner sind beispielsweise Schrittweiten für Abgleichswiderstände, welche mittels der Widerstandseinrichtung 58 gebildet sind, einstellbar. Es ist beispielsweise auch einstellbar, ob bei Widerstandsänderungen der Verlauf dieser Widerstandsänderung linear oder nichtlinear und beispielsweise exponentiell ist.

Weiterhin ist beispielsweise eine Schwelle für den Komparator 68 über einen entsprechenden Komparatoreingang einstellbar.

Die erste Programmierebene ist insbesondere eine Ebene, die beim Design einer Sensorvorrichtung berücksichtigt wird und in der eine Familientypeinstellung erfolgt.

Die Einstellungen sind dabei grundsätzlich an dem "nackten" elektronischen Bauteil 14 (vor Einbau in ein Gehäuse bzw. vor Bestückung auf einer Platine) möglich, oder nach der Bestückung auf der Platine, oder nach Einbau in das Gehäuse 12.

Nach Programmierung der ersten Programmierebene 80 ist diese verriegelbar. Es kann dabei eine Verriegelung von Einstellungen in der zweiten Programmierebene 82 erfolgen oder es erfolgt eine Gesamtverriegelung, nachdem die Einstellungen in den Programmierebenen 80, 82, 84 durchgeführt wurden.

Die Verriegelung kann dabei reversibel oder irreversibel sein. Beispielsweise kann eine irreversible Verriegelung vorgesehen sein, die jedoch eine Reset-Funktion 86 ermöglicht, über welche das elektronische Bauteil 14 in bestimmte Grundeinstellungen zurücksetzbar ist, und zwar in allen Programmierebenen 80, 82, 84 ("Default-Preset").

In der zweiten Programmierebene 82 ist eine Kennlinie der Sensorvorrichtung einstellbar. Dies erfolgt insbesondere über einen Teach-in-Abgleich oder direkt. Die Kennlinieneinstellung wird dabei insbesondere durch Einstellungen an der Widerstandseinrichtung 58 durchgeführt. Die grundlegenden Setup-Parameter für die Widerstandseinrichtung 58 wurden dabei bereits wie oben beschrieben in der ersten Programmierebene 80 eingestellt.

Die zweite Programmierebene 82 ist beispielsweise eine Programmierebene, auf die nach der Fertigstellung der Sensorvorrichtung 10 zugegriffen wird. In der zweiten Programmierebene 82 lässt sich die Sensorvorrichtung 10 (mit angeschlossener sensitiver Einrichtung 16) kalibrieren. Dadurch lässt sich die Kennlinie, das heißt die Input-Output-Übertragungsfunktion festlegen. Diese Einstellung erfolgt dabei an jeder individuellen Sensorvorrichtung 10 beispielsweise über ein Teach-in-Verfahren. In der zweiten Programmierebene 82 erfolgt eine individuelle Stückeinstellung.

Die zweite Programmierebene 82 ist insbesondere verriegelbar, wobei eine irreversible Verriegelung vorteilhaft ist. Insbesondere lässt sich die zweite Programmierebene auf ihre Grundeinstellung zurücksetzen. Dadurch kann beispielsweise eine fehlerhafte Sensorkalibrierung rückgängig gemacht werden.

Die dritte Programmierebene 84 dient beispielsweise dazu, um innerhalb einer Sensorfamilie (die Familieneinstellung erfolgt in der ersten Programmierebene 80) Unterklassen einzustellen. Die dritte Programmierebene 84 ist beispielsweise eine Logistikebene. Auf der dritten Programmierebene 84 ist beispielsweise einstellbar, von welchem Typ ein Schaltausgang ist (wie HSD - High Side Driver, LSD - Low Side Driver oder PUSH-PULL). Beispielsweise ist eine Schaltfunktion einstellbar, ob die Sensorvorrichtung ein Öffner oder Schließer ist. Beispielsweise ist auch ein Modus für die Anzeigeeinrichtung 42 insbesondere als Zustandsanzeige einstellbar. Weiterhin ist beispielsweise über die dritte Programmierebene 84 eine Gesamtverriegelung der Programmierebenen möglich. Die Gesamtverriegelung kann irreversibel sein.

Grundsätzlich kann beispielsweise noch eine vierte Programmierebene vorgesehen sein, an welcher ein Anwender eine Einstellung vornimmt.

Die Programmierebenen 80, 82, 84 sind derart hierarchisch angeordnet, dass über Einstellungen in der dritten Programmierebene 84 Einstellungen in der zweiten Programmierebene 82 und der ersten Programmierebene 80 nicht veränderbar sind. Ferner sind über Einstellungen in der zweiten Programmierebene 82 Einstellungen in der ersten Programmierebene 80 nicht modifizierbar.

Grundsätzlich ist dabei auch vorgegeben, dass, wenn eine Programmierebene nicht verriegelt ist, eine entsprechende Programmierung zu einem beliebigen Zeitpunkt vorgenommen werden kann.

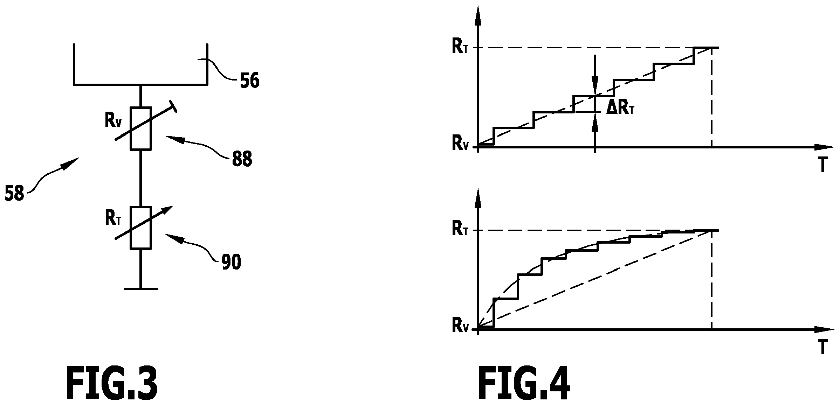

Die einstellbare Widerstandseinrichtung 58, von der ein Ersatzschaltbild in Figur 3 gezeigt ist, umfasst eine einstellbare Vorwiderstandseinrichtung 88 und eine einstellbare Trimmwiderstandseinrichtung 90. Ein Widerstandswert $R_V$ der Vorwiderstandseinrichtung 88 ist insbesondere in der ersten Programmierebene 80 einstellbar. Bestimmte Parameter der Trimmwiderstandseinrichtung 90 sind ebenfalls in der ersten Programmierebene 80 einstellbar. Insbesondere ist eine Schrittweite $\Delta R_T$ (Figur 4) einstellbar. Ferner ist der Verlauf bei Widerstandsänderungen einstellbar (Figur 4). In Figur 4 sind dabei ansteigende Verläufe gezeigt. Die Verläufe können grundsätzlich auch abfallend sein.

In der zweiten Programmierebene 82 ist der Widerstandswert $R_T$ der Widerstandseinrichtung 58 einstellbar, um einen Sensorabgleich durchzuführen.

Die Vorwiderstandseinrichtung 88 und die Trimmwiderstandseinrichtung 90 sind seriell geschaltet. Sie bilden ein Widerstandsnetzwerk, mittels welchem in der zweiten Programmierebene 82 eine (digitale oder analoge) Sensorkennlinie einstellbar ist.

In Figur 4 oben ist beispielhaft ein typischer Verlauf einer Widerstandsänderung während eines Abgleichvorgangs gezeigt. Der Vorwiderstandswert $R_V$ der Vorwiderstandseinrichtung 88 wurde bereits in der ersten Programmierebene 80 eingestellt und wird nicht mehr verändert. Beim Sensorabgleich in der zweiten Programmierebene 82 verläuft die Widerstandsänderung bei der Variation von Widerständen in Figur 4 oben linear.

Es ist auch möglich, dass der Verlauf der Widerstandsänderung nichtlinear ist (Figur 4 unten) und beispielsweise exponentiell. Ein solcher Verlauf kann beispielsweise vorteilhaft sein, wenn ein nichtlinearer Zusammenhang zwischen einem Ableichwiderstand und dem resultierenden Schaltabstand oder Messabstand kompensiert werden soll.

Die Vorwiderstandseinrichtung 88 umfasst beispielsweise eine Reihenschaltung von M Widerstandselementen $r_V$. Ein typischer Widerstandswert eines solchen Widerstandselements $r_V$ ist 3,2 kΩ. Über einen Multiplexer werden M Widerstände $r_V$ in Reihe geschaltet, sodass der Vorwiderstandswert $R_V = M \cdot r_V$ ist.

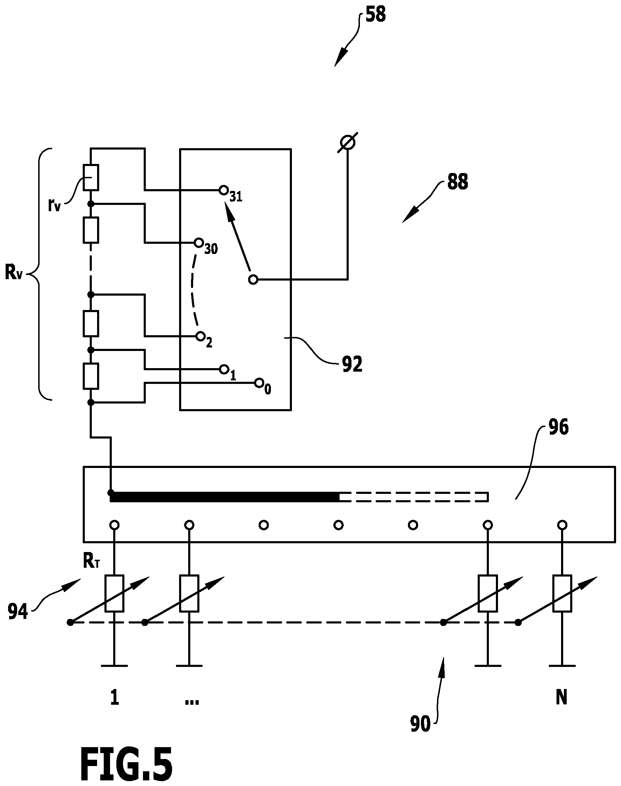

Ein Ausführungsbeispiel einer Widerstandseinrichtung 58, welches in Figur 5 gezeigt ist, umfasst in der Vorwiderstandseinrichtung 88 die in Serie schaltbaren Widerstände $r_V$ mit einem zugeordneten Multiplexer 92, über den (in der ersten Programmierebene 80) einstellbar ist, wie viele Widerstandselemente $r_V$ in Reihe geschaltet sind.

Die Trimmwiderstandseinrichtung 90 weist eine Mehrzahl von Reihen 94 auf, wobei in einer Reihe 94 individuelle Widerstandselemente $r_E$ in Reihe geschaltet sind. Die Reihen 94 sind parallel zueinander und es ist ein Balken-Schalter 96 vorgesehen, über welchen eine bestimmte Anzahl dieser Reihen 94 parallel anschließbar sind. Wenn N Reihen 94 kontaktiert sind, dann lässt sich eine Widerstandsauflösung $r_E/N$ erreichen. Wenn in der ersten Programmierebene 80 eine lineare Mode für eine Widerstandsänderung eingestellt wurde, das heißt wenn bei Widerstandsänderungen in der zweiten Programmierebene 82 der Widerstandswert linear hoch laufen soll, dann ergibt sich der Gesamtwiderstand $R_T$ der Trimmwiderstandseinrichtung 90 gemäß $T \cdot r_E/N$. Der Widerstandswert $R_T$ wird linear gemäß einer Digitalrampe (siehe Figur 4 oben) erhöht. Die konstante Stufenhöhe $\Delta R_T$ bei der Widerstandsänderung ist durch N festgelegt. Die laufende Variable T wird in der zweiten Programmierebene 82 durch Teach-In oder direkt eingestellt.

Es ist beispielsweise auch möglich, ein exponentielles Hochlaufen bei Widerstandsänderungen vorzusehen (Figur 4 unten). Es ergibt sich dabei ein Gesamtwiderstand $R_T$ als

$$R_T = \left[ \frac{1}{T \cdot r_E} + \frac{N-1}{T_{\max} \cdot r_E} \right]^{-1} \qquad (1)$$

$T_{\max}$ ist dabei der maximale Wert der Laufvariable T.

Der Wert $R_T$ wird dabei stufenweise nach einer e-Funktion erhöht. Die Stufenhöhe ist nicht konstant.

Sowohl der lineare Verlauf als auch der nichtlineare Verlauf lässt sich mit dem gleichen Widerstandsnetzwerk 58 und insbesondere mit der gleichen Trimmwiderstandseinrichtung 90 realisieren. Für einen exponentiellen Verlauf wird beispielsweise der Widerstandswert in der ersten Reihe 94 mit der Variable T hochgefahren und die restlichen Reihen 94 werden auf dem maximalen Wert $T_{\max} \cdot r_E$ festgehalten.

Wie oben erwähnt, wird dabei der Modus für die Widerstandsänderung in der ersten Programmierebene 80 eingestellt.

Das elektronische Bauteil 14 ist universell einsetzbar. Es ist für unterschiedliche Sensorfamilien einsetzbar, wobei der Einsatz über die erste Programmierebene 80 festgelegt wird.

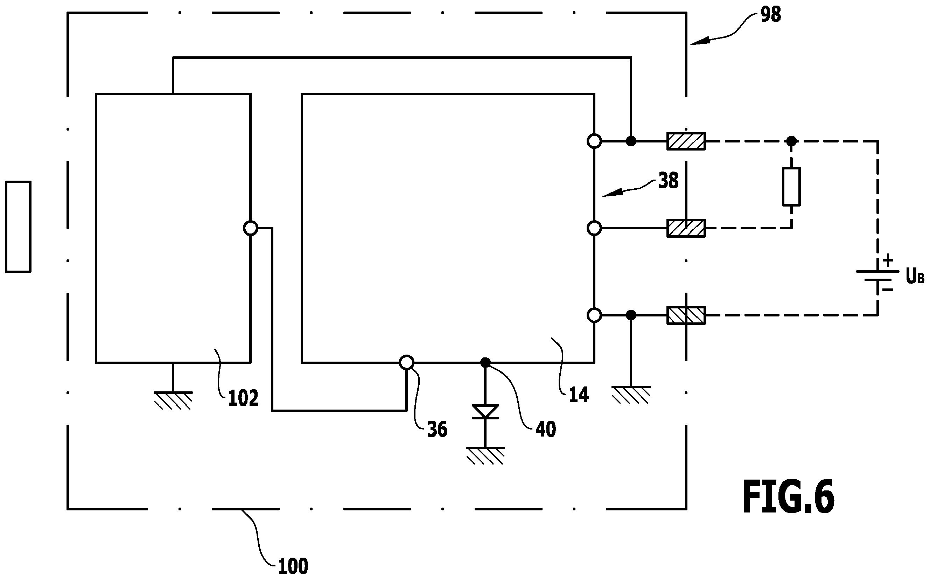

Es ist beispielsweise auch möglich, das elektronische Bauteil 14 für eine Sensorvorrichtung 98 (Figur 6) einzusetzen, bei welchem in einem Gehäuse 100 eine sensitive Einrichtung 102 angeordnet ist, welche schaltend ist. Die sensitive Einrichtung 102 ist beispielsweise eine kapazitive Einrichtung oder eine magnetfeldsensitive Einrichtung. In diesem Falle muss die sensitive Einrichtung 102 nicht an die Sensoreinheit 54 angeschlossen werden und insbesondere ist kein Oszillator 56 nötig. Es ist dann die sensitive Einrichtung 102 an den Anschluss 36 der ersten Anschlusseinrichtung 32 angeschlossen, wobei dieser Anschluss 36 in direkter signalwirksamer Verbindung mit dem Umschalter 66 steht.

In diesem Falle ist das elektronische Bauteil 14 kein Masterbauteil der Sensorvorrichtung 98, sondern eine Art Endstufe ("Backend") für die Sensorvorrichtung 98. In diesem Falle muss das elektronische Bauteil 14 die sensitive Einrichtung 102 nicht ansteuern.

Bei der Sensorvorrichtung 98 wird vor allem die Signalkonditionierungseinrichtung 64 und die Ausgangseinheit 74 des elektronischen Bauteils 14 genutzt.

Der Einsatz des elektronischen Bauteils 14 als "Endstufe" für die Sensorvorrichtung 98 lässt sich in der ersten Programmierebene 80 einstellen. In der zweiten Programmierebene 82 lässt sich wie oben beschrieben die Kennlinie der Sensorvorrichtung 98 einstellen. In der dritten Programmierebene 84 lassen sich bestimmte Sensorfunktionen einstellen.

Erfindungsgemäß wird ein elektronisches Bauteil 14 bereitgestellt, welches universell einsetzbar ist. Das elektronische Bauteil 14 ist für unterschiedliche Arten von Sensorvorrichtungen wie beispielsweise induktive Sensorvorrichtungen und kapazitive Sensorvorrichtungen einsetzbar. Die entsprechenden notwendigen Anpassungen für den unterschiedlichen Einsatz werden in der ersten Programmierebene 80 vorgenommen.

Das elektronische Bauteil 14 ist für unterschiedliche Sensorfamilien der gleichen Art einsetzbar. Die Sensorfamilie, für die das elektronische Bauteil 14 verwendet wird, ist durch die entsprechenden Einstellungen in der ersten Programmierebene 80 reflektiert.

Wenn die entsprechenden Einstellungen in der ersten Programmierebene 80 getroffen wurden, wobei diese erste Programmierebene 80 eine Designebene ist, können in einer Fertigungsebene entsprechende Kennlinien in der zweiten Programmierebene 82 eingestellt werden. Grundsätzlich ist dabei dieser Vorgang reversibel, sodass beispielsweise bei einer fehlerhaft eingestellten Kennlinie die entsprechende Sensorvorrichtung nicht verworfen werden muss, sondern der Einstellungsprozess rückgängig gemacht werden kann und neu durchgeführt werden kann.

In der dritten Programmierebene 84 lassen sich bestimmte Sensorfunktionen wie beispielsweise die Ausbildung als Öffner oder Schließer einstellen. Diese Funktionen werden softwaremäßig eingestellt, sodass keine entsprechende Hardware vorgehalten werden muss.

Es ist grundsätzlich so, dass das elektronische Bauteil 14 analoge und/oder digitale Ausgangssignale bereitstellen kann. Über die entsprechende sensitive Einrichtung lassen sich analoge Signale und/oder digitale Signale dem elektronischen Bauteil 14 bereitstellen. Beispielsweise werden über den Anschluss 34 analoge Signale in das elektronische Bauteil 14 eingekoppelt. Über den Anschluss 36 werden analoge Signale oder digitale Signale eingekoppelt. Insbesondere wenn das elektronische Bauteil 14 nur als Backend eingesetzt wird, bei dem die entsprechende sensitive Einrichtung an den Anschluss 36 angeschlossen ist, werden digitale Signale bereitgestellt. Das elektronische Bauteil 14 kann dann auch eingekoppelte analoge Signale in digitale Signale gegebenenfalls mit einer Auswertungsfunktionalität wandeln.

**Bezugszeichenliste**

| | |
|---|---|
| 10 | Sensorvorrichtung |
| 12 | Gehäuse |
| 14 | elektronisches Bauteil |
| 16 | sensitive Einrichtung |
| 18 | Spule |
| 20 | Kapazität |
| 22 | Target |
| 24 | Vorderseite |
| 26 | Anschluss |
| 28 | Anschluss |
| 30 | Anschluss |
| 32 | Erste Anschlusseinrichtung |
| 34 | Anschluss |
| 36 | Anschluss |
| 38 | Zweite Anschlusseinrichtung |
| 40 | Dritte Anschlusseinrichtung |
| 42 | Anzeigeeinrichtung |
| 44 | Leuchtdiode |
| 46 | Digitaleinheit |
| 48 | Taktgeber |
| 50 | Speichereinrichtung |
| 52 | Zentralprozessor |
| 54 | Sensoreinheit |
| 56 | Oszillator |
| 58 | Widerstandseinrichtung |
| 60 | Detektor |
| 61 | Anschluss |
| 62 | Kapazität |
| 63 | Anschluss |
| 64 | Signalkonditionierungseinrichtung |
| 66 | Umschalter |
| 68 | Komparator |

| 70 | Logikeinheit |
|---|---|
| 72 | Treiber |
| 73 | Temperaturgesteuerte Spannungsquelle |
| 74 | Ausgangseinheit |
| 76 | Ausgangsstufe |
| 78 | Kurzschlussdetektor |
| 80 | Erste Programmierebene |
| 82 | Zweite Programmierebene |
| 84 | Dritte Programmierebene |
| 86 | Reset-Funktion |
| 88 | Vorwiderstandseinrichtung |
| 90 | Trimmwiderstandseinrichtung |
| 92 | Multiplexer |
| 94 | Reihe |
| 96 | Balken-Schalter |
| 98 | Sensorvorrichtung |
| 100 | Gehäuse |
| 102 | sensitive Einrichtung |

**Patentansprüche**

1. Elektronisches Bauteil für eine Sensorvorrichtung, umfassend eine erste Anschlusseinrichtung (32) zum Anschluss einer sensitiven Einrichtung (16), welche durch ein Target (22) beeinflussbar ist, eine zweite Anschlusseinrichtung (38) für die externe Kommunikation, und eine Steuerungseinrichtung und/oder eine Auswertungseinrichtung, welche Ausgangssignale bereitstellt, wobei das Bauteil über die zweite Anschlusseinrichtung (38) programmierbar ist, mit einer ersten Programmierebene (80), in welcher Parameter für den Setup der Sensorvorrichtung einstellbar sind, und einer zweiten Programmierebene (82), in welcher eine Kennlinie der Sensorvorrichtung einstellbar ist, wobei die erste Programmierebene (80) der zweiten Programmierebene (82) hierarchisch übergeordnet ist und Einstellungen und/oder Einstellungsmöglichkeiten in der zweiten Programmierebene (82) abhängig sind von Einstellungen in der ersten Programmierebene (80), wobei das Bauteil eine Widerstandseinrichtung (58) aufweist, welche mindestens einen einstellbaren Widerstand umfasst.

2. Elektronisches Bauteil nach Anspruch 1, **dadurch gekennzeichnet, dass** die erste Anschlusseinrichtung (32) mindestens einen Anschluss (34) für eine sensitive Einrichtung (16) umfasst, welche ein oder mehrere sensitive Elemente aufweist, die auf elektromagnetische Felder reagieren, und insbesondere **gekennzeichnet durch** eine Sensoreinheit (54) zur Ansteuerung der sensitiven Einrichtung (16).

3. Elektronisches Bauteil nach einem der vorangehenden Ansprüche, **dadurch gekennzeichnet, dass** die erste Anschlusseinrichtung (32) mindestens einen Anschluss (36) für eine sensitive Einrichtung umfasst, für welche keine Ansteuerbarkeit durch das elektronische Bauteil vorgesehen ist.

4. Elektronisches Bauteil nach einem der vorangehenden Ansprüche, **dadurch gekennzeichnet, dass** die erste Anschlusseinrichtung (32) getrennte Anschlüsse (34, 36) für unterschiedliche Arten von sensitiven Einrichtungen aufweist.

5. Elektronisches Bauteil nach einem der vorangehenden Ansprüche, **dadurch gekennzeichnet, dass** in der ersten Programmierebene (80) mindestens eine der folgenden Einstellungen durchführbar ist: Einsatz des Bauteils, Einstellungen bezüglich der Art der sensitiven Einrichtung (16), Einstellungen zur Festlegung von Sensorkenndaten, wobei die Sensorkenndaten eine oder mehrere der Parameter maximaler Ausgangsstrom, Hysterese eines Ausgangsschaltsignals, Signalhöhe umfassen können, Einstellungen der Anpassung der sensitiven Einrichtung (16), Konfigurieren von Vorwiderstandswerten, Konfigurieren von Schrittwerten ($\Delta R_T$) bei Abgleichswiderständen, Konfigurieren des Werteverlaufs bei Abgleichswiderständen.

6. Elektronisches Bauteil nach einem der vorangehenden Ansprüche, **dadurch gekennzeichnet, dass** in der zweiten Programmierebene (82) ein Teach-in-Abgleich für die Kennlinie und/oder ein direktes Einstellen für die Kennlinie durchführbar ist.

**7.** Elektronisches Bauteil nach einem der vorangehenden Ansprüche, **gekennzeichnet durch** eine dritte Programmierebene (84), welche der zweiten Programmierebene (82) hierarchisch untergeordnet ist, und in welcher mindestens eine der Einstellungen Typ eines Schaltausgangs, Freigabe eines Schaltausgangs, Schaltfunktion als Öffner oder Schließer, Modus einer Anzeigeeinrichtung (42) einstellbar ist.

**8.** Elektronisches Bauteil nach einem der vorangehenden Ansprüche, **gekennzeichnet durch** eine dritte Anschlusseinrichtung (40) für eine Anzeigeeinrichtung (42) und/oder Sensorzustandsdaten.

**9.** Elektronisches Bauteil nach einem der vorangehenden Ansprüche, **dadurch gekennzeichnet, dass** eine Programmierebene (80; 82; 84) verriegelbar ist, und insbesondere, dass einstellbar ist, ob eine Programmierebene (80; 82; 84) reversibel oder irreversibel verriegelbar ist.

**10.** Elektronisches Bauteil nach einem der vorangehenden Ansprüche, **gekennzeichnet durch** eine Reset-Funktion (86), mittels welcher Einstellungen in einer oder mehreren oder allen Programmierebenen (80; 82; 84) auf vorgegebene Einstellungen zurücksetzbar sind.

**11.** Elektronisches Bauteil nach einem der vorangehenden Ansprüche, **dadurch gekennzeichnet, dass** eine Digitaleinheit (46) vorgesehen ist, und insbesondere, dass die Auswertungseinrichtung mindestens teilweise in die Digitaleinheit (46) integriert ist, und insbesondere, dass die Digitaleinheit (46) mindestens eines der folgenden Bestandteile umfasst: Taktgeber (48), Speichereinrichtung (50), Zentralprozessor (52).

**12.** Elektronisches Bauteil nach einem der vorangehenden Ansprüche, **dadurch gekennzeichnet, dass** eine Sensoreinheit (54) vorgesehen ist, welche mit der ersten Anschlusseinrichtung (32) in signalwirksamer Verbindung steht, und insbesondere, dass die Sensoreinheit (54) einen Oszillator (56) umfasst, und insbesondere, dass die Sensoreinheit (54) einen Detektor (60) für Signale der sensitiven Einrichtung (16) umfasst, und insbesondere **gekennzeichnet durch** mindestens einen Anschluss (61), an welchem Analogsignale des Detektors (60) abgreifbar sind.

**13.** Elektronisches Bauteil nach einem der vorangehenden Ansprüche, **dadurch gekennzeichnet, dass** eine Ausgangseinheit (74) vorgesehen ist, und insbesondere, dass die Ausgangseinheit (74) einen Kurzschlussdetektor (78) und/oder Überlastdetektor umfasst.

**14.** Elektronisches Bauteil nach einem der vorangehenden Ansprüche, **dadurch gekennzeichnet, dass** die Widerstandseinrichtung (58) eine Vorwiderstandseinrichtung (88) umfasst, deren Widerstandswert ($R_V$) einstellbar ist, und insbesondere, dass die Vorwiderstandseinrichtung (88) eine Mehrzahl von seriell geschalteten und/oder seriell schaltbaren Widerständen ($r_E$) aufweist, und insbesondere, dass die Widerstandseinrichtung (58) eine Trimmwiderstandseinrichtung (90) aufweist, wobei deren Widerstandswert ($R_T$) und der Verlauf bei Widerstandsänderungen einstellbar ist, und insbesondere, dass die Trimmwiderstandseinrichtung (90) eine Mehrzahl von parallel geschalteten und/oder parallel schaltbaren Widerständen aufweist, und insbesondere, dass einstellbar ist, ob der Verlauf der Widerstandsänderung linear oder nichtlinear und insbesondere exponentiell ist, und insbesondere **gekennzeichnet durch** ein Widerstandsnetzwerk, welches seriell schaltbare Widerstände und parallel schaltbare Widerstände umfasst, wobei eine Schaltkombination einstellbar ist.

**15.** Verwendung des Bauteils gemäß einem der vorangehenden Ansprüche als Masterbauteil für eine Sensorvorrichtung oder als Endstufe einer Sensorvorrichtung (10).

**16.** Sensorvorrichtung, umfassend ein Bauteil gemäß einem der Ansprüche 1 bis 14 und eine sensitive Einrichtung (16), welche an das Bauteil (14) angeschlossen ist, wobei insbesondere das Bauteil (14) und die sensitive Einrichtung (16) in dem gleichen Gehäuse (12) angeordnet sind.

**17.** Verfahren zum Konfigurieren einer Sensorvorrichtung gemäß Anspruch 16, bei dem in der ersten Programmierebene Setup-Parameter der Sensorvorrichtung eingestellt werden und anschließend in der zweiten Programmierebene eine Kennlinie eingestellt wird, und bei dem die erste und die zweite Programmierebene verriegelt werden, und insbesondere in einer dritten Programmierebene Sensorfunktionen eingestellt werden und die dritte Programmierebene verriegelt wird.

**Claims**

1. Electronic component for a sensor apparatus comprising a first terminal device (32) for connecting a sensitive device (16) which is influenceable by a target (22), a second terminal device (38) for the external communication, and a control device and/or an evaluation device which provides output signals, wherein the component is programmable via the second terminal device (38), comprising a first programming level (80) in which parameters for the setup of the sensor apparatus are adjustable and a second programming level (82) in which a characteristic curve of the sensor apparatus is adjustable, wherein the first programming level (80) is hierarchically superordinate to the second programming level (82) and adjustments and/or possibilities of adjustment in the second programming level (82) depend on adjustments in the first programming level (80), wherein the component has a resistance device (58) comprising at least one adjustable resistance.

2. Electronic component in accordance with claim 1, **characterized in that** the first terminal device (32) comprises at least one terminal (34) for a sensitive device (16) which has one or more sensitive elements that are reactive to electromagnetic fields, and in particular **characterized by** a sensor unit (54) for driving the sensitive device (16).

3. Electronic component in accordance with any one of the preceding claims, **characterized in that** the first terminal device (32) comprises at least one terminal (36) for a sensitive device for which no capability of being driven by the electronic component is provided.

4. Electronic component in accordance with any one of the preceding claims, **characterized in that** the first terminal device (32) has separate terminals (34, 36) for different types of sensitive devices.

5. Electronic component in accordance with any one of the preceding claims, **characterized in that** in the first programming level (80) at least one of the following adjustments is performable: use of the component, adjustments with respect to the type of sensitive device (16), adjustments to define characteristic data of the sensor, wherein the characteristic sensor data may comprise one or more of the parameters comprising maximum output current, hysteresis of an output switching signal and signal level, adjustments of the adaptation to the sensitive device (16), configuring of pre-resistance values, configuring of step values ($\Delta R_T$) for trim resistances, configuring of the course of values for trim resistances.

6. Electronic component in accordance with any one of the preceding claims, **characterized in that** in the second programming level (82) a teach-in tuning for the characteristic curve and/or a direct adjustment for the characteristic curve is performable.

7. Electronic component in accordance with any one of the preceding claims, **characterized by** a third programming level (84) which is hierarchically subordinate to the second programming level (82) and in which at least one of the following adjustments is adjustable: type of a switching output, enabling of a switching output, switching function normally closed or normally open, mode of an indicating device (42).

8. Electronic component in accordance with any one of the preceding claims, **characterized by** a third terminal device (40) for an indicating device (42) and/or sensor status data.

9. Electronic component in accordance with any one of the preceding claims, **characterized in that** a programming level (80; 82; 84) is lockable, and in particular **in that** it is adjustable whether a programming level (80; 82; 82) is lockable reversibly or irreversibly.

10. Electronic component in accordance with any one of the preceding claims, **characterized by** a reset function (86) by means of which adjustments in one or several or all of the programming levels (80; 82; 84) are resettable to predetermined settings.

11. Electronic component in accordance with any one of the preceding claims, **characterized in that** a digital unit (46) is provided, and in particular **in that** the evaluation device is at least partially integrated in the digital unit (46), and in particular **in that** the digital unit (46) comprises at least one of the following constituents: clock generator (48), memory device (50), central processor (52).

12. Electronic component in accordance with any one of the preceding claims, **characterized in that** a sensor unit (54) is provided which is operatively connected for signal communication with the first terminal device (32), and in particular **in that** the sensor unit (54) comprises an oscillator (56), and in particular **in that** the sensor unit (54) comprises a detector (60) for signals of the sensitive device (16), and in particular **characterized by** at least one terminal (61) at which analogue signals of the detector (60) are tappable.

13. Electronic component in accordance with any one of the preceding claims, **characterized in that** an output unit (74) is provided, and in particular **in that** the output unit (74) comprises a short-circuit detector (78) and/or an overload detector.

14. Electronic component in accordance with any one of the preceding claims, **characterized in that** the resistance device (58) comprises a pre-resistance device (88) whose resistance value ($R_V$) is adjustable, and in particular **in that** the pre-resistance device (88) comprises a plurality of resistances ($r_E$) which are connected in series and/or are connectable in series, and in particular **in that** the resistance device (58) comprises a trim resistance device (90), wherein the resistance value ($R_T$) of the trim resistance device and the course of the resistance value when resistance is changed are adjustable, and in particular **in that** the trim resistance device (90) comprises a plurality of resistances which are connected in parallel and/or are connectable in parallel, and in particular in that it is adjustable whether the course of the resistance value when resistance is changed is linear or non-linear and in particular exponential, and in particular **characterized by** a resistance network which comprises resistances that are connectable in series and resistances that are connectable in parallel, wherein a switching combination is adjustable.

15. Use of the component in accordance with any one of the preceding claims as a master component for a sensor apparatus or as an end stage of a sensor apparatus (10).

16. Sensor apparatus, comprising an electric component in accordance with any one of claims 1 to 14 and a sensitive device (16) which is connected to the component (14), in particular wherein the component (14) and the sensitive device (16) are arranged in the same housing (12).

17. Method of configuring a sensor apparatus in accordance with claim 16, in which method setup parameters of the sensor apparatus are adjusted in the first programming level and then a characteristic curve is adjusted in the second programming level, and in which the first and the second programming levels are locked, and in particular in that sensor functions are adjusted in a third programming level and the third programming level is locked.

**Revendications**

1. Composant électronique pour un dispositif de capteur, comprenant un premier système de raccordement (32) servant au raccordement d'un système (16) sensible, lequel peut être influencé par une cible (22), un deuxième système de raccordement (38) pour la communication externe, et un système de commande et/ou un système d'évaluation, lequel fournit des signaux de sortie, dans lequel le composant peut être programmé par l'intermédiaire du deuxième système de raccordement (38), avec un premier plan de programmation (80), dans lequel des paramètres peuvent être réglés pour la configuration du dispositif de capteur, et un deuxième plan de programmation (82), dans lequel une courbe caractéristique du dispositif de capteur peut être réglée, dans lequel le premier plan de programmation (80) est placé hiérarchiquement au-dessus du deuxième plan de programmation (82) et des réglages et/ou possibilités de réglage dans le deuxième plan de programmation (82) dépendent de réglages dans le premier plan de programmation (80), dans lequel le composant présente un système de résistance (58), lequel comprend au moins une résistance pouvant être réglée.

2. Composant électronique selon la revendication 1, **caractérisé en ce que** le premier système de raccordement (32) comprend au moins un raccordement (34) pour un système (16) sensible, lequel présente un ou plusieurs éléments sensibles, qui réagissent aux champs électromagnétiques, et caractérisé en particulier par une unité de capteur (54) servant à piloter le système (16) sensible.

3. Composant électronique selon l'une quelconque des revendications précédentes, **caractérisé en ce que** le premier système de raccordement (32) comprend au moins un raccordement (36) pour un système sensible, pour lequel aucune possibilité de pilotage par le composant électronique n'est prévue.

4. Composant électronique selon l'une quelconque des revendications précédentes, **caractérisé en ce que** le premier système de raccordement (32) présente des raccordements (34, 36) séparés pour différents types de systèmes sensibles.

5. Composant électronique selon l'une quelconque des revendications précédentes, **caractérisé en ce que** dans le premier plan de programmation (80) au moins un des réglages suivants peut être effectué : utilisation du composant, réglages quant au type du système (16) sensible, réglages servant à fixer des données caractéristiques de capteur, dans lequel les données caractéristiques de capteur peuvent comprendre un ou plusieurs des paramètres d'un courant de sortie maximal, d'une hystérèse d'un signal de commutation de sortie, de niveaux de signaux, des réglages de l'adaptation du système (16) sensible, la configuration de valeur de résistance en série, la configuration d'incréments ($\Delta R_T$) pour des résistances de compensation, la configuration de la variation de valeurs pour des résistances de compensation.

6. Composant électronique selon l'une quelconque des revendications précédentes, **caractérisé en ce que** dans le deuxième plan de programmation (82), une compensation d'apprentissage pour la courbe caractéristique et/ou un réglage direct pour la courbe caractéristique peuvent être effectués.

7. Composant électronique selon l'une quelconque des revendications précédentes, **caractérisé par** un troisième plan de programmation (84), lequel est placé hiérarchiquement sous le deuxième plan de programmation (82) et dans lequel au moins un des réglages, le type d'une sortie de commutation, le déblocage d'une sortie de commutation, une fonction de commutation, peut être réglé en tant que système d'ouverture ou système de fermeture, mode d'un système d'affichage (42).

8. Composant électronique selon l'une quelconque des revendications précédentes, **caractérisé par** un troisième système de raccordement (40) pour un système d'affichage (42) et/ou des données d'état de capteur.

9. Composant électronique selon l'une quelconque des revendications précédentes, **caractérisé en ce qu'**un plan de programmation (80 ; 82 ; 84) peut être verrouillé, et en particulier qu'il est possible de régler si un plan de programmation (80 ; 82 ; 84) peut être verrouillé de manière réversible ou de manière irréversible.

10. Composant électronique selon l'une quelconque des revendications précédentes, **caractérisé par** une fonction de réinitialisation (86), au moyen de laquelle des réglages dans un ou plusieurs ou tous les plans de programmation (80, 82 ; 84) peuvent être ramenés à des réglages prédéfinis.

11. Composant électronique selon l'une quelconque des revendications précédentes, **caractérisé en ce qu'**une unité numérique (46) est prévue, et en particulier que le système d'analyse est intégré au moins en partie dans l'unité numérique (46), et en particulier que l'unité numérique (46) comprend au moins un des constituants suivants : sonde de cadence (48), système de stockage (50), processeur central (52).

12. Composant électronique selon l'une quelconque des revendications précédentes, **caractérisé en ce qu'**est prévue une unité de capteur (54), laquelle est reliée pour la transmission de signaux au premier système de raccordement (32), et en particulier que l'unité de capteur (54) comprend un oscillateur (56), et en particulier que l'unité de capteur (54) comprend un détecteur (60) pour des signaux du système (16) sensible, et en particulier **caractérisé par** au moins un raccordement (61), au niveau duquel des signaux analogiques du détecteur (60) peuvent être prélevés.

13. Composant électronique selon l'une quelconque des revendications précédentes, **caractérisé en ce qu'**une unité de sortie (74) est prévue, et en particulier que l'unité de sortie (74) comprend un détecteur de court-circuit (78) et/ou un détecteur de surcharges.

14. Composant électronique selon l'une quelconque des revendications précédentes, **caractérisé en ce que** le système de résistance (58) comprend un système de résistance en série (88), dont la valeur de résistance ($R_V$) peut être réglée, et en particulier que le système de résistance en série (88) présente une multitude de résistances ($r_E$) branchées en série et/ou pouvant être commutées en série, et en particulier que le système de résistance (58) présente un système de résistance de compensation (90), dans lequel sa valeur de résistance ($R_T$) et l'évolution dans le cas de variations de résistance peuvent être réglées, et en particulier que le système de résistance de compensation (90) présente une multitude de résistances branchées en parallèle et/ou pouvant être commutées en parallèle, et en particulier qu'il est possible de régler si l'évolution de la variation de résistance est linéaire ou non linéaire et en particulier exponentielle, et en particulier **caractérisé par** un réseau de résistances, lequel comprend des résistances pouvant être commutées en série et des résistances pouvant être commutées en parallèle, dans lequel une combinaison de commutations peut être réglée.

15. Utilisation du composant selon l'une quelconque des revendications précédentes, en tant que composant maître pour un dispositif de capteur ou en tant qu'étage final d'un dispositif de capteur (10).

16. Dispositif de capteur comprenant un composant selon l'une quelconque des revendications 1 à 14 et un système (16) sensible, lequel est raccordé au composant (14), dans lequel en particulier le composant (14) et le système (16) sensible sont disposés dans le même boîtier (12).

17. Procédé de configuration d'un dispositif de capteur selon la revendication 16, où des paramètres de configuration du dispositif de capteur sont réglés dans le premier plan de programmation puis une courbe caractéristique est réglée dans le deuxième plan de programmation, et où le premier et le deuxième plan de programmation sont verrouillés, et en particulier des fonctions de capteur sont réglées dans un troisième plan de programmation et le troisième plan de programmation est verrouillé.

FIG.1

EP 2 550 740 B1

FIG.2

**FIG.3**

$\Delta R_T$

**FIG.4**

EP 2 550 740 B1

FIG.5

FIG.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4123828 C2
- US 5408132 A
- DE 10025662 A1
- DE 4200207 C1
- DE 4331555 A1